(19) Europäisches Patentamt

European Patent Office

Office européen des brevets

(11) **EP 1 069 690 A2**

(12) **EUROPÄISCHE PATENTANMELDUNG**

(43) Veröffentlichungstag:
**17.01.2001 Patentblatt 2001/03**

(51) Int. Cl.⁷: **H03M 5/12**

(21) Anmeldenummer: **00113732.2**

(22) Anmeldetag: **28.06.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **15.07.1999 DE 19932692**

(71) Anmelder:
**Patent-Treuhand-Gesellschaft für elektrische Glühlampen mbH**
**81543 München (DE)**

(72) Erfinder: **Pilz, Axel**
**74632 Neuenstein (DE)**

(54) **Verfahren zur Abtastung biphase codierter digitaler Signale**

(57) Die Erfindung betrifft ein Abtastungsverfahren für biphase codierte digitale Signale durch Empfangsmittel, die mindestens einen Signaleingang mit umschaltbarer Signalflankensensitivität oder mindestens zwei Signaleingänge mit unterschiedlicher Signalflankensensitivität zum Empfang derartiger Signale besitzen. Die zu empfangenden Signale werden pro Datenbit genau einmal, nämlich während der Übertragung des ersten Halbbits abgetastet. Die Signalflanken (F1-F5) eines jeden Bits werden zur Synchronisation des Signaleinganges mit dem Steuersignal und zur Erkennung von Übertragungsfehlern ausgenutzt. An jede Signalabtastung (S1-S5) schließt sich ein Zeitfenster (Δt) an, innerhalb dem der Empfang der Signalflanke des aktuellen Bits erwartet und als zulässig gewertet wird. Die Signalflankensensitivität des mindestens einen Signaleinganges wird in Abhängigkeit von dem abgetasteten Logikpegel des ersten Halbbits des jeweils übertragenen Bits des Signals eingestellt.

FIG. 1

**Beschreibung**

Die Erfindung betrifft ein Verfahren zur Abtastung biphase codierter digitaler Signale gemäß des Patentanspruchs 1. Insbesondere betrifft die Erfindung auch ein Verfahren zur zentralen Ansteuerung der elektrischen Verbraucher einer Beleuchtungsanlage, beispielsweise der Betriebsgeräte der Lampen, mittels biphase codierter digitaler Steuersignale.

I. Technisches Gebiet

Bei der biphasen Codierung eines digitalen Signals wird jedes Bit des digitalen Signals in zwei Halbbits unterschiedlichen Logikzustandes unterteilt. In jedem Bit des Signals besitzen das erste und zweite Halbbit unterschiedliche Logikpegel und es tritt zwischen diesen beiden Halbbits eine fallende oder eine steigende Signalflanke auf, je nach dem, ob sich das erste oder das zweite Halbbit auf dem Logikpegel "1" befindet. Bei einer regulären Datenübertragung müssen sich daher die Logikpegel "0" und "1" periodisch abwechseln.

Üblicherweise wird zum Empfang biphase codierter digitaler Signale zunächst auf die Flanke des Startbits des empfangenen Signals synchronisiert und eine Abtastung dieses Signals mit einer Periodendauer gestartet, die kleiner ist als die Übertragungsdauer eines Halbbits. Es erfolgt also mindestens eine Abtastung pro Halbbit. Die Qualität dieses Verfahrens, insbesondere die Erkennung von Übertragungsfehlern, verbessert sich mit steigender Anzahl der Einzelabtastungen je Halbbit. Mit Hilfe einer Auswertungsvorrichtung wird aus den Einzelabtastungen des Logikpegels des Halbbits ein Mittelwert gebildet und durch Vergleich mit zwei Schwellwerten der Logikpegel dieses Halbbits zu "0" oder "1" bestimmt. Mit der Erhöhung der Anzahl der Einzelabtastungen wird zwar die Fehlererkennung verbessert, gleichzeitig erhöht sich aber auch die Systembelastung und führt bei sogenannten Multi-Tasking-Systemen zu einer Verlangsamung des Systems.

II. Darstellung der Erfindung

Es ist die Aufgabe der Erfindung, ein Verfahren zur Abtastung biphase codierter digitaler Signale durch Empfangsmittel, die mindestens einen Signaleingang mit umschaltbarer Signalflankensensitivität besitzen, bereitzustellen, das eine möglichst geringe Anzahl von Abtastungen des empfangenen Signals erfordert und trotzdem eine Synchronisierung auf die Übertragung sowie eine Erkennung von Übertragungsfehlern gewährleistet.

Diese Aufgabe wird erfindungsgemäß durch die Merkmale des Patentanspruchs 1 gelöst. Besonders vorteilhafte Ausführungen der Erfindung sind in den Unteransprüchen beschrieben.

Bei dem erfindungsgemäßen Verfahren zur Abtastung biphase codierter digitaler Signale durch Empfangsmittel, die mindestens einen Signaleingang mit umschaltbarer Signalflankensensitivität oder mindestens zwei Signaleingänge mit unterschiedlicher Signalflankensensitivität zum Empfang derartiger Signale besitzen, wird zum Empfangen eines derartigen Signals

    A) die Signalflankensensitivität des mindestens einen Signaleinganges auf eine fallende Signalflanke eingestellt, falls sein Ruhezustands-Logikpegel "1" ist, und seine Signalflankensensitivität auf eine steigende Signalflanke eingestellt, falls sein Ruhezustands-Logikpegel "0" ist, um den Beginn eines Signals zu detektieren, oder der Signaleingang mit der entsprechenden Signalflankensensitivität aktiviert, um den Beginn eines Signals zu detektieren,
B) eine Abtastung des Logikpegels des ersten Halbbits des momentan empfangenen Bits des Signals durchgeführt,
C) die Signalflankensensitivität des mindestens einen Signaleinganges in Abhängigkeit von dem Logikpegel des abgetasteten ersten Halbbits des momentan empfangenen Bits eingestellt, oder in Abhängigkeit von dem Logikpegel des abgetasteten ersten Halbbits des momentan empfangenen Bits der Signaleingang mit der entsprechenden Signalflankensensitivität aktiviert
D) ein Zeitfenster vorgegeben, währenddem das Auftreten der Signalflanke zwischen dem ersten und zweiten Halbbit des vorgenannten Bits des Signals erwartet und als zulässig gewertet wird,
E) geprüft, ob die vorgenannte Signalflanke in dem vorgegebenen Zeitfenster aufgetreten ist, und falls die Signalflanke zwischen dem ersten und zweiten Halbbit innerhalb des vorgegebenen Zeitfensters detektiert worden ist, werden die Verfahrensschritte B) bis E) für das nächste Bit des Signals wiederholt, oder anderenfalls der Signalempfang abgebrochen.

Das erfindungsgemäße Verfahren sieht nur eine einzige Abtastung des Signals pro Bit vor. Es ist vollkommen ausreichend, nur jeweils das erste Halbbit eines jeden Datenbits des Signals einmal abzutasten, um das Signal auszuwerten und Fehler in der Codierung des Signals zuverlässig zu erkennen. Die in jedem Bit des Signals vorkommende Signalflanke wird erfindungsgemäß zur Synchronisation des mindestens eine Signaleinganges mit dem empfangenen Signal und zur Erkennung von Fehlern bei der Codierung des Signals ausgenutzt. Die Vorgabe eines Zeitfensters, während der die Signalflanke zwischen dem ersten und zweiten Halbbit detektiert werden kann, begrenzt die zulässigen Schwankungen der zeitlichen Bitlänge und damit auch die zulässigen Schwankungen der Signalübertragungsrate.

Das erfindungsgemäße Verfahren kann vorteilhafterweise bei einer Beleuchtungsanlage angewandt werden, die mehrere Lampen, mindestens ein Betriebsgerät für die Lampen und mindestens eine Steuereinheit zur Ansteuerung des mindestens einen Betriebsgerätes aufweist.

III. Beschreibung des bevorzugten Ausführungsbeispiels

Nachstehend wird die Erfindung anhand eines bevorzugten Ausführungsbeispiels näher erläutert. Es zeigen:

Figur 1     die Abtastung eines fehlerfreien Steuersignals mittels des erfindungsgemäßen Verfahrens

Figur 2     die Erkennung einer unzulässigen Bitübertragungsdauer im Startbit mittels des erfindungsgemäßen Verfahrens

Figur 3     die Erkennung eines Störsignals innerhalb des Steuersignals mittels des erfindungsgemäßen Verfahrens

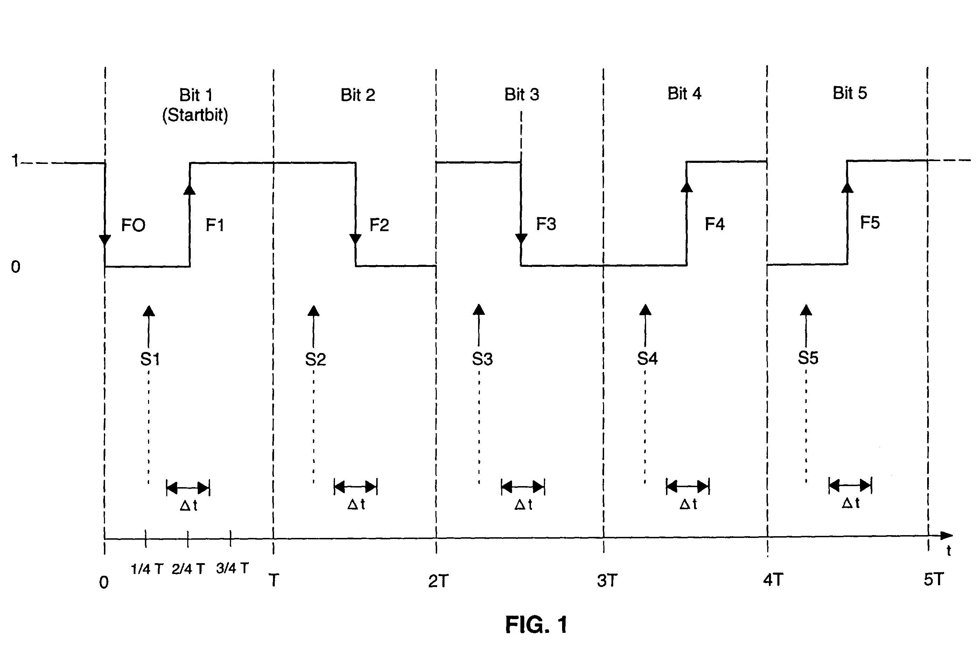

Mit Hilfe der Figuren 1 bis 3 wird das erfindungsgemäße Verfahren an einem Ausführungsbeispiel näher beschrieben. Wie bereits oben angedeutet, läßt sich das erfindungsgemäße Verfahren vorteilhafterweise bei eine Beleuchtungsanlage anwenden, die mehrere Leuchten und eventuell weitere elektrische Verbraucher, wie zum Beispiel Servomotoren zur Bedienung von Jalousien etc., sowie mindestens eine zentrale Steuereinheit zur Ansteuerung der Leuchten und eventueller anderer elektrischer Verbraucher aufweist. Jede Leuchte ist mit einer oder mehreren Lampen und einem elektrischen Betriebsgerät zum Betreiben der Lampen dieser Leuchte ausgestattet. Zwischen der zentralen Steuereinheit und den Betriebsgeräten sowie eventuellen weiteren elektrischen Verbrauchern bestehen bidirektionale Verbindungsleitungen, die die Übertragung von biphase codierten digitalen Spannungssignalen zwischen der Steuereinheit und den Betriebsgeräten sowie eventuellen anderen elektrischen Verbrauchern in beide Richtungen ermöglichen. Bei den Betriebsgeräten handelt es sich um elektronische Vorschaltgeräte (EVG), die jeweils mit einem Mikrocontroller zum Empfang und zur Auswertung der von der zentralen Steuereinheit abgesandten Steuersignale sowie für Rückmeldungen an die zentrale Steuereinheit ausgestattet sind. Jeder Mikrocontroller besitzt einen Steuersignal-Eingang mit umschaltbarer Signalflankensensitivität zum Empfang biphase codierter digitaler Steuersignale. Mittels dieser Steuersignale werden einzelne oder gruppenweise zusammengefaßte Betriebsgeräte zentral durch die Steuereinheit angesteuert und die an die Betriebsgeräte angeschlossenen Lampen ein- bzw. ausgeschaltet oder gedimmt, bzw. deren Betriebszustände abgefragt.

Im Ruhezustand befinden sich die Übertragungsleitungen zwischen dem Steuersignal-Ausgang der zentralen Steuereinheit und den Steuersignal-Eingängen der Mikrocontroller auf dem Logikpegel "1". Um den Beginn eines Steuersignals detektieren zu können, ist die Flankensensitivität der Steuersignal-Eingänge der Mikrocontroller auf eine fallende Signalflanke eingestellt, da das erste Halbbit des Startbits eines jeden Steuersignals mit dem Logikpegel "0" beginnen muß. Die biphase codierten digitalen Steuersignale besitzen eine vorgegebene Länge von beispielsweise 16 Bit. Sie beginnen mit einem Startbit und enden mit einem Stopbit. Die Steuersignale enthalten die Betriebsadresse der anzusteuernden Betriebsgeräte und einen oder mehrere Steuerbefehle für diese Betriebsgeräte.

In Figur 1 ist ein Beispiel eines fehlerfreien, biphase codierten digitalen Steuersignals ausschnittweise und schematisch dargestellt. An den Steuersignal-Eingängen der Mikrocontroller wird die fallende Flanke F0 des Startbits des Steuersignals detektiert. Zum Zeitpunkt $t=1/4\ T$ , wobei T die Übertragungsdauer eines Bits des Steuersignals bezeichnet, erfolgt die erste Abtastung S1 des Steuersignals. Dabei wird der Logikpegel "0" des ersten Halbbits des Bits 1 (Startbit) abgetastet. Außerdem wird die Flankensensitivität der Steuersignal-Eingänge in Abhängigkeit von dem abgetasteten Logikpegel "0" des ersten Halbbits des Startbits auf eine steigende Signalflanke umgeschaltet. Das Umschalten der Signalflankensensitivität eines Steuersignal-Einganges geschieht beispielsweise mit Hilfe eines im Mikroprozessor integrierten Registers durch Setzen bzw. Rücksetzen eines Bits. Zu dem Zeitpunkt $1/8\ T$ nach der Abtastung S1 des ersten Halbbits des Startbits wird ein Zeitfenster $\Delta t$ geöffnet, dessen Dauer im vorliegenden Beispiel $1/4\ T$ beträgt, währenddessen der Empfang der steigenden Signalflanke F1 zwischen dem ersten und zweiten Halbbit des Startbits erwartet wird. Bei dem in Figur 1 abgebildeten Steuersignal tritt die Signalflanke F1 des Startbits zum erwarteten Zeitpunkt $t=1/2\ T$ und damit innerhalb der vorgegebenen Zeitspanne $\Delta t$ nach der Abtastung S1 auf. Die Signalflanke F1 wird daher als zulässig bewertet. Zum Zeitpunkt $t=5/4\ T$ wird die nächste Abtastung S2 des Steuersignals durchgeführt. Mit der Abtastung S2 wird der Logikpegel "1" des ersten Halbbits von Bit 2 ermittelt. Die Flankensensitivität des Steuersignal-Eingangs bzw. der Steuersignal-Eingänge wird, da bei der Abtastung S2 eine logische "1" detektiert wurde, auf eine fallende Signalflanke eingestellt. Wiederum $1/8\ T$ nach der Abtastung S2 wird das vorgegebene Zeitfenster $\Delta t$ aktiviert, während der die fallende Signalflanke F2 von Bit 2 erwartet wird. Die Signalflanke F2 zwischen dem ersten und zweiten Halbbit von Bit 2 tritt zum Zeitpunkt $t=3/2\ T$ auf. Dieser Zeitpunkt liegt innerhalb des Zeitfensters $\Delta t$ nach der Abtastung S2 und die Signalflanke F2 wird daher als zulässig gewertet. Zum Zeitpunkt $t=9/4\ T$ erfolgt die dritte Abtastung S3 des Steuersignals. Dabei wird der Logikpegel "1" des ersten Halbbits von Bit 3 detektiert. Die Flankensensitivität des Steuersignal-Eingangs bzw. der Steuersignal-Eingänge wird, entsprechend dem detektierten Logikpegel "1", auf eine fallende Signalflanke eingestellt. Im zeitlichen Abstand von 1/8 T nach der Abtastung S3 wird wieder das Zeitfenster Δt aktiviert, während dem der Empfang der fallenden Signalflanke F3 von Bit 3 erwartet wird. Die Signalflanke F3 von Bit 3 wird zum erwarteten Zeitpunkt t=5/2 T empfangen. Diese Signalflanke wird als zulässig bewertet, da sie innerhalb des Zeitfensters Δt nach der Abtastung S3 aufgetreten ist. Zum Zeitpunkt t=13/4 T erfolgt die vierte Abtastung S4 des Steuersignals. Hierbei wird der Logikpegel "0" des ersten Halbbits von Bit 4 ermittelt. Entsprechend des ermittelten Logikpegels "0" wird die Flankensensitivität des Steuersignal-Eingangs bzw. der Steuersignal-Eingänge auf eine steigende Signalflanke eingestellt. Im zeitlichen Abstand 1/8 T nach der Abtastung S4 wird außerdem ein Zeitfenster der Länge Δt aktiviert, innerhalb dem der Empfang der steigenden Signalflanke F4 von Bit 4 erwartet wird. Die Signalflanke F4 wird zum Zeitpunkt t=7/2 T detektiert und liegt damit innerhalb des zulässigen Zeitfensters Δt nach der Abtastung S4. Zum Zeitpunkt t=17/4 T erfolgt die Abtastung S5 des Logikpegels "0" des ersten Halbbits von Bit 5. Die Signalflankensensitivität des Steuersignal-Eingangs bzw. der Steuersignal-Eingänge wird dementsprechend auf eine steigende Signalflanke eingestellt. Innerhalb des Zeitfensters Δt, das 1/8 T nach der erfolgten Abtastung S5 beginnt, wird die erwartete Signalflanke F5 von Bit 5 detektiert und damit als zulässig gewertet. Vollkommen analog dazu wird das Verfahren für alle weiteren Bits des Steuersignals fortgeführt. Die Abtastung des Steuersignals erfolgt bitweise, im Abstand der für die Übertragung eines Bits erforderlichen Zeit T und jeweils während des Empfangs des ersten Halbbits. An jede Abtastung schließt sich im zeitlichen Abstand von 1/8 T ein Zeitfenster der Länge Δt an, während der die Signalflanke des gerade übertragenen und empfangenen Bits des Steuersignals erwartet und als zulässig bewertet wird. Das Ende des Steuersignals wird durch ein oder mehrere Stopbits markiert und/oder durch einen Bitzähler festgestellt. Beginn und Ende der Zeitfenster Δt nach jeder Abtastung werden mittels eines in den Mikrocontrollern integrierten Timers erzeugt.

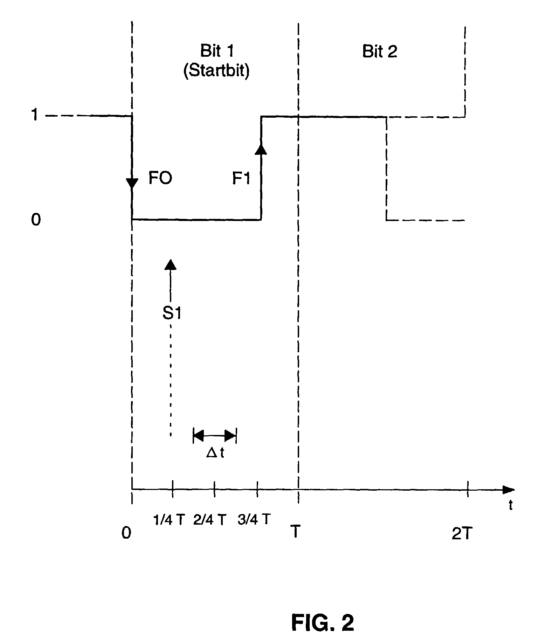

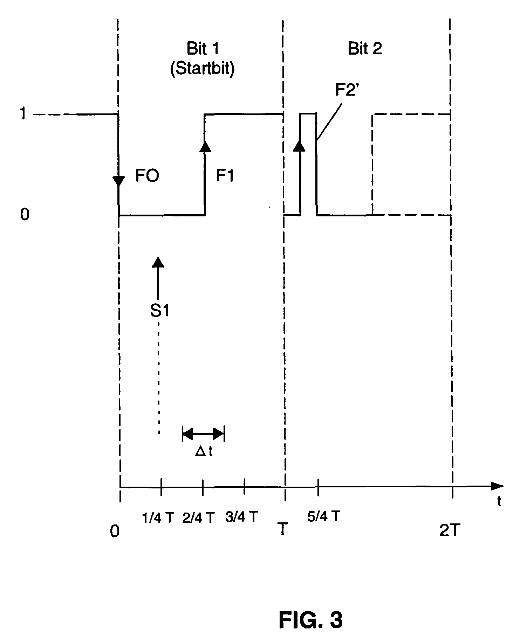

Die Figuren 2 und 3 zeigen die Erkennung von fehlerhaften Steuersignalen mittels des erfindungsgemäßen Signalabtastungsverfahrens. In Figur 2 ist ein Beispiel eines Steuersignals mit einem fehlerhaften Startbit dargestellt. An den Steuersignal-Eingängen der Mikrocontroller wird die fallende Flanke F0 des Startbits des Steuersignals detektiert. Zum Zeitpunkt t=1/4 T , wobei T die Übertragungsdauer eines Bits des Steuersignals bezeichnet, erfolgt die erste Abtastung S1 des Steuersignals. Dabei wird der Logikpegel "0" des ersten Halbbits des Startbits abgetastet. Außerdem wird die Flankensensitivität der Steuersignal-Eingänge in Abhängigkeit von dem abgetasteten Logikpegel "0" des ersten Halbbits des Startbits auf eine steigende Signalflanke umgeschaltet. Gleichzeitig mit der Abtastung S1 des ersten Halbbits des Startbits wird ein Zeitfenster Δt festgelegt, dessen Dauer oder Länge im vorliegenden Beispiel 1/4 T beträgt und während dem der Empfang der steigenden Signalflanke F1 zwischen dem ersten und zweiten Halbbit des Startbits erwartet wird. Die erwartete Signalflanke F1 des Startbits tritt nicht zum erwarteten Zeitpunkt T/2, sondern deutlich später auf. Sie wird erst nach Ablauf des Zeitfensters Δt an dem Steuersignal-Eingang bzw. den Steuersignal-Eingängen detektiert. Damit wird die Signalflanke F1 als unzulässig gewertet und der Steuersignalempfang abgebrochen. Auf diese Weise werden vom erfindungsgemäßen Abtastungsverfahren Timing-Fehler und unzulässige Schwankungen der Übertragungsrate (Baudrate) erkannt.

In Figur 3 ist ein mit einem Störsignal überlagertes Steuersignal dargestellt. Das Störsignal tritt während der Übertragung bzw. des Empfangs des ersten Halbbits von Bit 2 auf. der Empfang und die Abtastung des Startbits und die Einstellung der Flankensensitivität verlaufen auf die gleiche Weise wie bereits bei dem Steuersignal gemäß Figur 1 beschrieben wurde. Die steigende Signalflanke F2' des Störsignals wird detektiert und als unzulässig gewertet, da sie außerhalb des Zeitfensters Δt nach der Abtastung S1 und vor der Definition des nächstes Zeitfensters Δt aufgetreten ist. Der Steuersignalempfang wird daher abgebrochen.

Die Erfindung beschränkt sich nicht auf das oben näher erläuterte Ausführungsbeispiel und auch nicht auf die oben beschriebene Anwendung des Verfahrens auf eine Beleuchtungsanlage. Das erfindungsgemäße Abtastungsverfahren für biphase codierte digitale Signale kann generell für entsprechend codierte digitale Datenübertragung eingesetzt werden, sofern die Empfänger mit Signaleingängen ausgestattet sind, die eine Umschaltung der Signalflankensensitivität erlauben, oder die Empfänger Signaleingänge mit unterschiedlicher Signalflankensensitivität besitzen, die mit einer geeigneten Logikschaltung verbunden sind, oder aber die Empfänger mindestens einen Signaleingang zur Detektion fallender Signalflanken und mindestens einen Eingang zur Detektion steigender Signalflanken aufweisen, zwischen denen entsprechend des Resultats der letzten Abtastung gewechselt wird.

**Patentansprüche**

1.    Verfahren zur Abtastung biphase codierter digitaler Signale durch Empfangsmittel, die mindestens einen Signaleingang mit umschaltbarer Signalflankensensitivität oder mindestens zwei Signaleingänge mit unterschiedlicher Signalflankensensitivität zum Empfang derartiger Signale besitzen, wobei

A) die Signalflankensensitivität des mindestens einen Signaleinganges mit umschaltbarer Signalflankensensitivität auf eine fallende Signalflanke (F0) eingestellt wird, falls sein Ruhezustands-Logikpegel "1" ist, und die Signalflankensensitivität des mindestens einen Signaleinganges auf eine steigende Signalflanke gesetzt wird, falls sein Ruhezustands-Logikpegel "0" ist, oder der Signaleingang mit der entsprechenden Signalflankensensitivität aktiviert wird, um den Beginn eines Signals zu detektieren,

B) eine Abtastung des Logikpegels des ersten Halbbits des momentan empfangenen Bits des Signals durchgeführt wird,

C) die Signalflankensensitivität des mindestens einen Signaleinganges in Abhängigkeit von dem Logikpegel des abgetasteten ersten Halbbits des momentan empfangenen Bits eingestellt wird, oder in Abhängigkeit von dem Logikpegel des abgetasteten ersten Halbbits des momentan empfangenen Bits der Signaleingang mit der entsprechenden Signalflankensensitivität aktiviert wird,

D) ein Zeitfenster (Δt) vorgegeben wird, währenddem das Auftreten der Signalflanke (F1, F2, F3, F4, F5) zwischen dem ersten und zweiten Halbbit des vorgenannten Bits des Signals erwartet und als zulässig gewertet wird,

E) geprüft wird, ob die vorgenannte Signalflanke (F1, F2, F3, F4, F5) innerhalb des vorgegebenen Zeitfensters (Δt) aufgetreten ist, und falls die Signalflanke (F1, F2, F3, F4, F5) zwischen dem ersten und zweiten Halbbit innerhalb des vorgegebenen Zeitfensters (Δt) detektiert worden ist, die Verfahrensschritte B) bis E) für das nächste Bit des Signals wiederholt werden, oder anderenfalls der Signalempfang abgebrochen wird.

2. Verfahren nach Anspruch 1, dadurch gekennzeichnet, daß für jedes Bit des zu empfangenen Signals höchstens eine Logikpegelabtastung durchgeführt wird.

3. Verfahren nach Anspruch 1, dadurch gekennzeichnet, daß nach jeder Abtastung (S1, S2, S3, S4, S5) ein Zeitfenster (Δt) gemäß Verfahrensschritt D) geöffnet wird.

4. Verfahren nach Anspruch 1, dadurch gekennzeichnet, daß das Zeitfenster (Δt) höchstens so lang wie die Übertragungsdauer (T) eines Bits ist.

5. Verfahren nach Anspruch 1, dadurch gekennzeichnet, daß die Abtastung der ersten Halbbits in konstanten Zeitabständen (T) durchgeführt wird.

6. Anwendung des Verfahrens nach einem der vorstehenden Ansprüche auf eine Beleuchtungsanlage, die mehrere Lampen, mindestens ein Betriebsgerät für die Lampen und mindestens eine Steuereinheit zur Ansteuerung des mindestens einen Betriebsgerätes mittels biphase codierter digitaler Steuersignale aufweist.

FIG. 1

EP 1 069 690 A2

**FIG. 2**

**FIG. 3**